# DEMANDE DE BREVET EUROPEEN

(11) **EP 2 479 785 A1**
(43) Date de publication de la demande: **25.07.2012**
(21) Numéro de dépôt: 12354009.8
(22) Date de dépôt: 23.01.2012
(51) Int. Cl.: H01L 21/336, H01L 29/786, H01L 21/265, H01L 29/66

(54) **Dispositif à effet de champ muni d'une zone barrière de diffusion de dopants localisée et procédé de réalisation**

(30) Priorité: 24.01.2011 FR 1100202
(71) Demandeur: Commissariat à l'Énergie Atomique et aux Énergies Alternatives, 75015 Paris (FR)
(72) Inventeur: Grenouillet, Laurent, 38140 Rives (FR); Le Tiec, Yannick, 38920 Crolles (FR); Posseme, Nicolas, 29660 Carantec (FR); Vinet, Maud, 38140 Rives (FR)
(74) Mandataire: Talbot, Alexandre

(57) **Abrégé**

Le dispositif à effet de champ comporte une électrode de grille sacrificielle ayant des parois latérales recouvertes par des espaceurs latéraux (8) formée sur un film en matériau semi-conducteur (2). Le substrat comporte un substrat de support (4), une couche électriquement isolante (5) et un film semi-conducteur (2). Les électrodes de source/drain (6) sont formées dans le film en matériau semi-conducteur (2) et sont disposées de part et d'autre de l'électrode de grille (12). Un élément barrière de diffusion est implanté au travers de l'espace vide laissé par la grille sacrificielle de manière à former une zone de diffusion modifiée (11) sous les espaceurs latéraux (8). La zone de diffusion modifiée (11) est une zone où la mobilité des impuretés dopantes est réduite comparée aux électrodes de source/drain (6).

## Description

### Domaine technique de l'invention

L'invention est relative à un dispositif à effet de champ.

L'invention est également relative à un procédé de réalisation d'un tel dispositif à effet de champ.

### État de la technique

Avec la réduction continue de leurs dimensions, les dispositifs actifs des circuits intégrés, comme les transistors, sont de plus en plus difficiles à réaliser. De nouvelles architectures sont mises en oeuvre afin de former des transistors qui tiennent compte des phénomènes physiques parasites de plus en plus présents et responsables des dégradations des performances électriques. En parallèle, des nouveaux schémas d'intégration sont également mis en place afin de contourner des difficultés dans les procédés de réalisation et obtenir des dispositifs fonctionnels.

La diminution des dimensions du transistor se traduit principalement par une diminution de la longueur du transistor, une diminution de la longueur du canal de conduction, c'est-à-dire une diminution de la distance qui sépare les électrodes de source et de drain.

De manière classique, l'électrode de grille est formée sur le substrat ce qui permet de placer le canal de conduction et les électrodes de source et de drain. Les électrodes de source et drain sont formées, par la suite, au moyen de l'implantation ionique d'une impureté dopante en utilisant l'électrode de grille comme un masque d'implantation. Cette technique permet un auto-alignement des électrodes de source et de drain par rapport à l'électrode de grille. L'étendue et le profil de dopage dans les électrodes de source et de drain sont généralement obtenus au moyen de deux étapes d'implantation successives d'une impureté dopante. La première étape d'implantation est une implantation tiltée qui vise à former une zone dopée sous une partie des espaceurs latéraux du transistor. La deuxième étape d'implantation est une implantation verticale qui forme des zones très dopées hors du volume délimité par l'électrode de grille avec ses espaceurs latéraux.

Afin de former un transistor performant qui soit compatible avec des contraintes de consommation et/ou de puissance, il est nécessaire d'avoir des zones de source/drain les plus dopées possible pour minimiser la résistance d'accès du transistor. Il est donc important d'incorporer une grande quantité de dopants dans les zones de source/drain, mais également de réaliser une bonne activation des dopants incorporés.

L'obtention d'un bon transistor passe également par la réalisation de jonctions abruptes entre le canal de conduction et les électrodes de source/drain. Plus la jonction est abrupte et plus le courant de fuite du transistor devrait être faible. Ainsi, pour avoir un transistor présentant de bonnes caractéristiques en consommation, c'est-à-dire avec des fuites limitées, il est intéressant d'avoir un canal non dopé.

Comme cela est indiqué plus haut, les électrodes de source et de drain sont formées au moyen d'une ou plusieurs étapes d'implantation d'une impureté dopante. L'étape d'implantation est suivie d'un recuit d'activation/diffusion qui permet de guérir une partie des défauts créés lors de l'implantation et de placer le plus possible d'impuretés dopantes dans des sites électriquement actifs. Comme le recuit est réalisé à haute température, il y a diffusion des impuretés dopantes dans le transistor.

Afin, d'avoir des transistors performants, il apparaît évident qu'une jonction abrupte ne peut être obtenue qu'au moyen d'un budget thermique limité et donc d'une diffusion maîtrisée. Cependant, ce budget thermique est imposé par les équipements de recuit et par la recherche d'une activation suffisante des dopants et/ou d'une guérison suffisante des défauts.

Une autre technique de dopage consiste à déposer par épitaxie un matériau semi-conducteur sur les zones de source/drain du transistor. Le matériau semi-conducteur est déposé avec un budget thermique qui permet de placer la majorité des impuretés dopantes directement dans des sites électriquement actifs. Cependant, il est nécessaire de réaliser la diffusion des dopants depuis la partie épitaxiée jusque dans le reste des zones de source/drain au moyen d'un recuit de diffusion.

Avec la diminution continue de la longueur de grille, les écarts de longueur effective entre les dispositifs, liés aux aléas du procédé de fabrication, se traduisent par des différences de comportement de plus en plus marquées ce qui est problématique pour le bon fonctionnement du circuit intégré.

### Objet de l'invention

On constate qu'il existe un besoin de prévoir un transistor à effet de champ ayant une longueur de grille mieux définie qui soit plus robuste vis-à-vis des aléas du procédé de fabrication.

On tend à combler ce besoin au moyen d'un dispositif selon les revendications annexées et plus particulièrement qui comporte :
- un substrat comportant successivement un substrat de support, une couche électriquement isolante et un film semi-conducteur,
- une électrode de grille ayant des parois latérales recouvertes par des espaceurs latéraux,
- des première et seconde électrodes de source/drain formées dans le film en matériau semi-conducteur, les première et seconde électrodes de source/drain étant disposées de part et d'autre de l'électrode de grille et dopées par une première impureté dopante,
- un canal de conduction formé dans le film semi-conducteur et séparant les première et seconde électrodes de source/drain, le canal de conduction étant disposé face à l'électrode de grille,
   dispositif dans lequel le film semi-conducteur, le canal de conduction et la première électrode de source/drain sont séparés par une zone de diffusion modifiée disposée dans le prolongement d'un des espaceurs latéraux et reliant la couche électriquement isolante à l'espaceur latéral associé, la zone de diffusion modifiée comportant un élément barrière de diffusion de la première impureté dopante, les concentrations en élément barrière dans le canal de conduction et la première électrode de source/drain étant inférieures à la concentration en élément barrière dans la zone de diffusion modifiée.

On constate également qu'il existe un besoin de prévoir un procédé de réalisation d'un tel transistor qui soit facile à mettre en oeuvre et qui soit, de préférence, facilement co-intégrable avec les procédés de réalisation des circuits électroniques.

Le dispositif est réalisé selon un procédé selon les revendications annexées et plus particulièrement comprenant les étapes suivantes :
- prévoir un substrat muni d'un film en matériau semi-conducteur recouvert par une électrode de grille sacrificielle et des espaceurs latéraux, les espaceurs latéraux recouvrant les parois latérales de l'électrode de grille sacrificielle,
- éliminer l'électrode de grille sacrificielle de manière à former une zone vide bordée par les espaceurs latéraux,
- réaliser une implantation ionique tiltée d'un élément barrière de diffusion avec un angle non nul par rapport à la surface du film en matériau semi-conducteur de manière à former dans le film en matériau semi-conducteur, à travers la zone vide, sous les espaceurs latéraux, une zone dopée par un élément barrière de diffusion à une première impureté dopante des futures électrodes de source/drain,
- former une électrode de grille en matériau électriquement conducteur.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

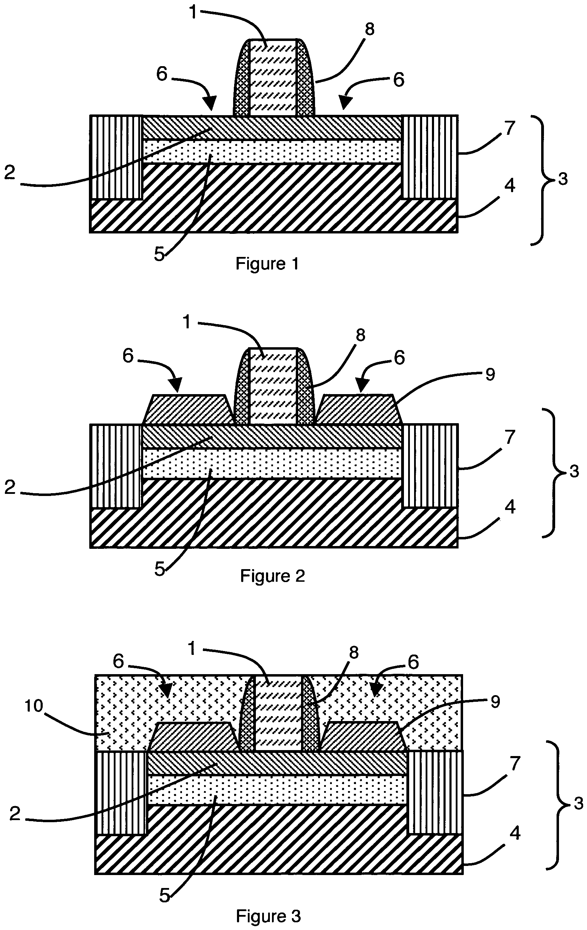

- les figures 1 à 6 représentent, de manière schématique, en vue de coupe, différentes étapes de réalisation d'un dispositif.

### Description de modes de réalisation préférentiels de l'invention

Comme cela est illustré à la figure 1, une électrode de grille 1 sacrificielle est formée sur un film en matériau semi-conducteur 2 d'un substrat 3. L'électrode de grille 1 sacrificielle est éventuellement séparée du film en matériau semi-conducteur 2 par un diélectrique de grille (non représenté) qui peut être sacrificiel ou non.

Le substrat 3 peut être de type semi-conducteur sur isolant et comporter successivement un substrat de support 4, une couche électriquement isolante 5 et le film en matériau semi-conducteur 2. Le film en matériau semi-conducteur 2 est une couche dite active car elle est destinée à intégrer un ou plusieurs transistors à effet de champ ou d'autres dispositifs.

Selon les modes de réalisation, le film semi-conducteur 2 peut être formé par un seul et même matériau semi-conducteur ou par une pluralité de films semi-conducteurs.

Le substrat 3 comporte alors successivement, le substrat de support 4, la couche électriquement isolante 5, le film en matériau semi-conducteur 2 et l'électrode de grille 1.

Le substrat 3 peut également être un substrat massif, par exemple un substrat en silicium sur lequel l'électrode de grille 1 est formée.

Les électrodes de source/drain 6 ou les futures électrodes de source/drain sont disposées de part et d'autre de l'électrode de grille 1 et séparées par un canal de conduction.

Dans un mode de réalisation particulier, un motif d'isolation 7 électriquement isolant est formé dans le substrat 3 pour définir la zone active du transistor. Le motif d'isolation 7 permet d'isoler électriquement le futur transistor et les électrodes de source/drain 6 du reste du substrat 3. L'électrode de grille s'étend avantageusement sur chacune de ses extrémités au-dessus du motif d'isolation 7 de manière à bien délimiter les zones de source et drain et éviter tout court-circuit.

L'électrode de grille 1 sacrificielle est recouverte sur ses parois latérales par des espaceurs latéraux 8 en matériau électriquement isolant. Les espaceurs 8 sont formés après l'électrode de grille 1 sacrificielle au moyen d'un dépôt conforme du matériau électriquement isolant suivi d'une gravure anisotrope. Les espaceurs latéraux 8 permettent de régler la distance entre les implantations des zones intermédiaires et le bord de l'électrode de grille. Ils empêchent également tout court-circuit entre l'électrode de grille 1 et le film semi-conducteur 2. Les espaceurs latéraux peuvent être absents dans les zones où l'électrode de grille 1 est formée sur le motif d'isolation 7. Dans un mode de réalisation particulier, les espaceurs latéraux 8 ne sont qu'un seul et même espaceur qui fait le tour de l'électrode de grille 1. Dans la vue de coupe illustrée à la figure 1, les espaceurs latéraux 8 séparent l'électrode de grille 1 sacrificielle des zones de source/drain 6.

Dans un mode de réalisation avantageux illustré à la figure 2, une épitaxie sélective de matériau semi-conducteur 9 est réalisée au niveau des électrodes 6 de source et de drain de manière à surélever la surface de ces électrodes 6 par rapport à la position du canal de conduction et réduire l'enfoncement des électrodes de source/drain 6 dans la profondeur du substrat 3 ce qui permet d'améliorer les performances électriques du dispositif final.

Le matériau semi-conducteur 9 déposé peut être identique ou non à celui formant initialement le film semi-conducteur 2. Le matériau semi-conducteur 9 peut être dopé ou non dopé.

Dans un mode de réalisation qui peut être combiné avec le précédent, un second espaceur latéral (non représenté) est formé sur le premier espaceur latéral 8, de préférence, après la réalisation de l'étape d'épitaxie sélective pour obtenir une plus grande marge de manoeuvre dans les étapes d'implantation à venir et/ou dans la siliciuration des électrodes 6.

A ce stade de la réalisation, il est également possible d'effectuer la formation de zones de transition de dopage au moyen d'une implantation d'impuretés dopantes entre le canal et les futures zones de source et drain 6. L'implantation est réalisée avec un angle prédéterminé qui évite une implantation perpendiculaire à la surface du substrat. Ainsi, une certaine quantité de dopants est implantée sous les espaceurs 8. La zone de transition de dopage est une zone dopée du film semi-conducteur 2 qui permet d'éviter le passage direct du canal de conduction aux zones de source/drain 6.

La seconde série d'espaceurs latéraux permet d'augmenter la surface de substrat qui est masquée lors des étapes d'implantation, par exemple lors de l'implantation des zones de source et de drain et/ou lors de la formation des zones de transition faiblement dopées entre les électrodes de source/drain 6 et la canal. De cette manière, les zones dopées de la source et du drain sont écartées ce qui permet de réaliser plus facilement la diffusion des dopants sans risquer un court-circuit du canal et donc la perte de l'effet transistor.

Dans une variante de réalisation, plusieurs zones de transition de dopages successives peuvent être réalisées.

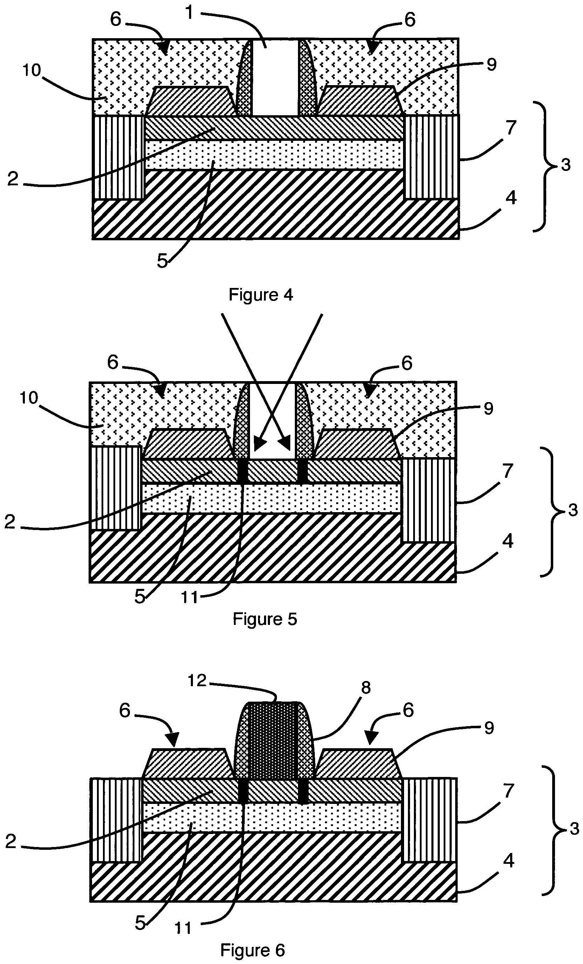

Comme cela est illustré aux figures 3 et 4, la grille 1 sacrificielle est ensuite éliminée de manière à avoir accès au substrat 3 ou au diélectrique de grille au niveau du canal de conduction.

Dans un mode de réalisation avantageux illustré à la figure 3, le substrat est protégé pour éliminer facilement la grille 1 sacrificielle sans risquer de détériorer les autres éléments présents sur le substrat 3. Une fois la grille éliminée, il y a accès au substrat ou au diélectrique de grille. Selon les modes de réalisation employés, le diélectrique de grille peut être éliminé ou conservé.

Dans le mode de réalisation particulier illustré à la figure 3, un matériau de recouvrement 10 est déposé sur le substrat de manière à recouvrir la grille 1 sacrificielle. Le matériau de recouvrement 10 est gravé partiellement de manière à permettre l'accès à la grille 1 sacrificielle. Dans un mode de réalisation encore plus particulier, l'accès à la grille 1 sacrificielle est obtenu au moyen d'une étape de photolithographie additionnelle qui permet de localiser la gravure de la couche de recouvrement 10 au-dessus de la grille 1 sacrificielle. Dans un autre cas de figure, le matériau de recouvrement 10 est aplani jusqu'à atteindre la grille 1 sacrificielle, par exemple par polissage mécanique et/ou par gravure plasma ou humide. Ces deux techniques peuvent également être combinées en réalisant l'étape d'aplanissement avant l'ouverture localisée par photolithographie et gravure.

Il est également possible de réaliser les étapes de photographie et gravure en premier afin, par exemple, de réduire la topographie de surface et accéder à la grille 1 par aplanissement.

Après élimination de la grille, le matériau de recouvrement 10 peut être éliminé ou conservé.

Comme cela est illustré à la figure 5, une fois la grille 1 sacrificielle éliminée, un matériau barrière de diffusion est implanté sous les espaceurs 8 pour former des zones de diffusion modifiée 11 dans le film semi-conducteur 2.

L'implantation est réalisée à travers le volume vide laissé par la grille sacrificielle bordée par les espaceurs latéraux 8. Les zones de diffusion modifiées sont faces aux espaceurs 8 et représentent des zones du film semi-conducteur 2 dans lesquelles la vitesse de diffusion de certaines impuretés électriques formant les électrodes 6 est réduite par rapport à la vitesse de diffusion dans le canal et/ou dans les zones de source/drain 6. Les zones de diffusion limitées sont des zones du film semi-conducteur 2 qui sont dopées par le matériau barrière et qui sont, de préférence, dans le prolongement des espaceurs 8.

Les zones de diffusion modifiées sont des zones de diffusion réduite pour les impuretés dopantes formant les électrodes de source/drain 6. De cette manière, les impuretés dopantes provenant des électrodes de source/drain 6 ont plus de difficultés à atteindre le canal de conduction. De plus, comme les impuretés dopantes se déplacent moins vites dans les zones 11 que dans le reste du film 2, les écarts de position des électrodes de source/drain qui définissent la longueur du canal sont réduites. Il en ressort que les longueurs de canal sont plus homogènes sur un même substrat ou entre différents substrats.

L'implantation est réalisée tiltée, c'est-à-dire que l'implantation est réalisée avec un angle différent de la perpendiculaire à la surface du substrat. L'implantation est réalisée avec un angle différent de la perpendiculaire à l'interface entre le substrat et l'électrode de grille ou le diélectrique de grille.

L'axe d'implantation relie l'électrode de source à l'électrode de drain et est préférentiellement perpendiculaire à la largeur de la grille de manière à éviter une contamination parasite du canal. L'axe d'implantation est ici inclus dans le plan de coupe illustré.

L'angle d'inclinaison lors de l'implantation est choisi de manière à localiser le matériau barrière de diffusion sous les espaceurs et donc à l'interface entre le canal et les zones dopées formant les électrodes de drain et de source 6.

L'angle d'implantation est choisi de manière à laisser une partie centrale du canal de conduction dépourvue d'élément barrière de diffusion ce qui permet d'avoir une zone du canal avec une mobilité élevée.

Les zones de diffusion modifiée 11 sont disposées à l'interface entre le canal de conduction et les électrodes de source et drain 6. Le canal est un volume du matériau semi-conducteur 2 qui est non dopé ou faiblement dopé (par des impuretés électriquement actives) et disposé sous l'électrode de grille. Les électrodes de source/drain 6 sont des volumes dopés par la première impureté dopante, disposées de part et d'autre de l'électrode de grille et qui s'enfoncent légèrement sous les espaceurs latéraux 8.

De manière encore plus préférentielle, les zones de diffusion modifiée 11 sont dans le prolongement des espaceurs 8 et de préférence avec une largeur qui est inférieure à celle des espaceurs. La zone de diffusion modifiée 11 ne s'étend pas au-delà des espaceurs ce qui permet de réduire l'influence du matériau barrière sur la mobilité du canal et sur l'activation des dopants dans les électrodes 6.

Avantageusement, l'angle d'implantation est choisi suffisamment différent de la perpendiculaire au substrat de manière à ne pas implanter de matériau barrière dans le canal délimité par l'ancienne grille 1. Cependant, l'écart à la perpendiculaire avec le matériau semi-conducteur 2 est suffisamment faible pour qu'une partie du matériau barrière soit implanté dans le matériau semi-conducteur sous les espaceurs 8. Il y a formation dans le film semi-conducteur 2 de deux zones de diffusion modifiée 11 qui sont séparées par le canal de conduction dépourvu de matériau barrière.

L'angle d'implantation est défini en fonction des dimensions du trou ou de la tranchée qui permet l'accès au substrat à travers le volume de la grille 1 sacrificielle.

Dans l'exemple illustré à la figure 5, l'angle d'implantation est défini en fonction des dimensions de l'ancienne grille 1, c'est-à-dire en fonction de la hauteur des espaceurs 8 et de la longueur de la grille 1 (la distance séparant les deux espaceurs 8). En effet, dans ce mode de réalisation la hauteur de la grille correspond à la hauteur des espaceurs et à la hauteur du matériau de recouvrement 10. La tangente de l'angle d'implantation maximal est égale au rapport entre la longueur de grille et la hauteur des espaceurs 8. Au-delà de cette valeur, le matériau barrière de diffusion n'est pas en mesure d'atteindre le substrat 3. La tangente de l'angle d'implantation minimal est égale au rapport entre la demi-longueur de grille et la hauteur de la grille sacrificielle. Avec un angle d'implantation égal ou inférieur à cette valeur, tout le canal est implanté avec le matériau barrière et les performances électriques sont réduites.

Dans le cas où l'accès à l'électrode de grille a été réalisé en formant un trou dans le matériau de recouvrement 10 qui alors est plus épais que l'électrode de grille et que les espaceurs 8, il faut tenir compte de la longueur de l'ouverture du trou et de la hauteur de matériau de recouvrement 10 pour trouver l'angle adapté.

De manière avantageuse, l'implantation du matériau barrière est réalisée avec un angle égal ou très légèrement inférieur à l'angle maximal d'implantation.

Comme l'angle maximal d'implantation est fonction des dimensions de la grille 1 sacrificielle (figure 5), il est avantageux de réaliser une étape d'implantation par dimension de grille afin d'avoir les meilleures conditions de fonctionnement pour chaque longueur de transistor.

En réalisant l'implantation du matériau barrière, à travers la zone vide de l'ancienne grille 1 sacrificielle, il est possible de placer les zones de diffusion modifiée 11 au plus près du canal. Le canal (dépourvu de matériau barrière) est séparé des électrodes de source/drain 6 par une zone de diffusion modifiée 11. Cela permet également d'utiliser une énergie d'implantation plus faible et des conditions opératoires plus faciles en comparaison d'une implantation depuis l'extérieur de la grille pour définir un canal de même longueur.

Lors des recuits thermiques, la zone de diffusion modifiée 11 empêche une diffusion des impuretés dopantes jusque dans le canal. Il est alors possible d'avoir des transistors avec une faible longueur de grille tout en profitant de l'effet bloquant des zones 11 qui évitent un court-circuit du transistor.

Le matériau barrière est un matériau qui bloque ou réduit la diffusion des atomes dopants utilisés pour former les zones de source et de drain 6 et/ou les zones de transition de dopage. De cette manière, le dispositif est plus robuste aux aléas de réalisation sur les bilans thermiques ce qui évite d'avoir une très grande fluctuation sur la longueur électrique de la grille (la distance séparant deux zones dopées et qui est généralement inférieure à la longueur physique de la grille).

Dans un mode de réalisation avantageux, le matériau barrière est du carbone car il a un effet sur les cinétiques de diffusion du bore et du phosphore qui sont utilisés pour former les zones dopées des transistors nMOS ou pMOS. Cependant, d'autres matériaux peuvent être utilisés comme par exemple l'azote ou l'oxygène. Il est également possible de dissocier le matériau barrière utilisé pour les transistors nMOS et celui utilisé pour les transistors pMOS. Il y a alors une première étape d'implantation avec un premier matériau barrière pour un premier type de transistor et une seconde étape d'implantation avec un second matériau barrière pour un second type de transistors. Cette dissociation permet d'implanter des matériaux différents ou le même matériau, mais à des concentrations différentes.

Après l'implantation du matériau barrière, le substrat est, de préférence, soumis à un recuit d'activation afin de placer le matériau barrière en position substitutionnelle et le rendre plus efficace sur la diffusion des dopants.

De manière avantageuse, les zones de source/drain 6 sont protégées lors de l'étape d'implantation du matériau barrière de manière à éviter un blocage du matériau dopant dans les électrodes de source/drain. La protection est réalisée préférentiellement par le matériau de recouvrement 10 qui a servi à protéger le substrat 3 pour accéder à la grille sacrificielle 1.

Dans un mode particulier de réalisation, les électrodes de source/drain ne sont pas protégées lorsqu'une épitaxie sélective a été réalisée. De cette manière, la surface supérieure des électrodes de source/drain est plus haute que la surface supérieure du canal de conduction. Lors de l'implantation du matériau barrière, ce dernier est localisé dans la partie supérieure des électrodes de source/drain 6. Cette partie supérieure peut éventuellement être éliminée afin de conserver des électrodes de source/drain sans matériau barrière. Le matériau barrière est alors localisé dans la partie supérieure des zones de source/drain 6 alors que la première impureté dopante est implantée à une profondeur plus importante.

Une fois le matériau barrière implanté sous les espaceurs latéraux 8, une nouvelle grille 12 est formée dans la zone laissée vide par la grille sacrificielle. L'électrode de grille 12 est séparée du substrat 3 par un matériau diélectrique de grille, un matériau électriquement isolant, par exemple, l'oxyde de silicium, l'oxyde de silicium nitruré ou un matériau présentant une constante diélectrique plus élevée comme l'oxyde d'hafnium.

La suite du procédé de réalisation du transistor peut être effectuée de manière conventionnelle car le transistor comporte une électrode de grille 12 séparant deux électrodes de source/drain.

De manière préférentielle, si les électrodes de sources et drain 6 sont formées par implantation ionique, l'impureté dopante est implantée dans une zone différente de la zone 11 de manière à éviter les problèmes de non-activation de l'impureté dopante à cause du matériau barrière. Cette distinction géographique est facile à mettre en oeuvre car les implantations sont réalisées séparément dans le schéma d'intégration présenté. L'implantation en matériau barrière est réalisée en passant à l'intérieur de l'électrode de grille alors que les implantations en impuretés dopantes sont réalisées en passant à l'extérieur de l'électrode de grille.

Le transistor présente classiquement un canal de conduction séparant les électrodes de source/drain 6. L'interface entre les électrodes de source/drain et le canal est formée, de préférence, dans les zones à diffusion modifiée 11 ce qui permet de réduire l'influence du matériau barrière sur l'activation des impuretés dopantes et sur la mobilité du canal.

A titre d'exemple le procédé de réalisation, suivant la formation de l'électrode de grille 12, est effectué de la manière suivante. Le matériau de recouvrement 10 est éliminé et un matériau isolant dopé est déposé. Le matériau isolant dopé est par exemple un verre dopé avec du bore ou du phosphore (de type BSG ou PSG) ou un matériau diélectrique déposé à la tournette.

Un recuit de diffusion est ensuite réalisé afin de faire migrer les dopants du matériau isolant dopé vers les électrodes de source et de drain 6. Le matériau isolant dopé fournit une quantité importante de dopants dans les zones de source et de drain 6 et la barrière de diffusion 11 empêche que les dopants provenant des électrodes de source/drain 6 ne se rejoignent dans le canal. Il est alors possible d'obtenir des électrodes de source/drain 6 très dopées tout en conservant une zone canal peu ou pas dopée et en profitant de l'effet important de la barrière de diffusion 11 disposée sous les espaceurs latéraux.

Le matériau isolant dopé est ensuite éliminé et les électrodes de source/drain sont siliciurées.

Le matériau barrière permet de former dans le film semi-conducteur, des zones présentant des vitesses de diffusion différentes dans un axe reliant l'électrode de source à l'électrode de drain. Deux zones à vitesse de diffusion élevée sont séparées par une zone à vitesse de diffusion plus faible comportant le matériau barrière. Les électrodes de source/drain présentent une vitesse de diffusion élevée car elles sont dépourvues de matériau barrière. L'absence de matériau barrière permet d'avoir une bonne répartition des dopants et une bonne activation des dopants ce qui est favorable à une résistance d'accès faible. Cela permet également d'avoir des profils de dopants conventionnels avec un budget thermique limité ce qui n'est pas possible quand le matériau barrière empêche ou limite la diffusion des dopants dans les électrodes de source/drain 6.

Dans le mode de réalisation décrit ci-dessus, une zone de diffusion limitée est formée entre le canal et la source et entre le canal et le drain. Cependant, il est également possible de ne former la zone de diffusion limitée qu'entre le canal et une des électrodes 6. Ce mode de réalisation autorise une moins bonne maîtrise de la longueur de grille car un seul côté présente une vitesse de diffusion limitée. Ce mode de réalisation peut être formé simplement en implantant le matériau barrière d'un seul côté du canal alors que dans le cas illustré à la figure 3, l'implantation est réalisée des deux côtés. Cela permet également de former des zones 11 avec des étendues et/ou des concentrations différentes entre la source et le drain.

Dans un mode de réalisation préférentiel, deux transistors sont réalisés sur le substrat. Le premier transistor est réalisé avec une taille inférieure au second transistor, c'est-à-dire que la longueur de grille du premier transistor (la distance séparant l'électrode de source et de l'électrode de drain) est inférieure à la longueur de grille du second transistor. Dans une variante de réalisation, les premiers et second transistors sont de type opposés (un transistor nMOS et un transistor pMOS).

Comme les deux transistors sont soumis au même budget thermique ou ont une partie du budget thermique en commun, il est important de ne pas court-circuiter un des transistors en cherchant à former l'autre transistor.

Afin de rendre le premier transistor plus robuste vis-à-vis du budget thermique nécessaire au second transistor, le premier transistor comporte l'implantation du matériau barrière sous les espaceurs latéraux. Ainsi, en modifiant la vitesse de diffusion des dopants le long d'un axe passant par le canal et reliant les deux électrodes de source et drain, il est possible d'accroître virtuellement la distance qui sépare les deux électrodes de source/drain. Dans ce cas de figure, le second transistor ne présente pas de zones à diffusion modifiée. Dans un mode de réalisation particulier, la grille sacrificielle du premier transistor est également une grille sacrificielle pour le second transistor. La grille sacrificielle 1 du second transistor est conservée lors de l'implantation du matériau barrière puis elle est éliminée pour former ensuite la grille 12.

Dans un autre mode de réalisation, la grille sacrificielle 1 du premier transistor correspond à la grille définitive du second transistor.

A titre d'exemple, pour une grille ayant une longueur égale à 20nm et une hauteur égale à 80nm, l'angle d'implantation préférentiel est égal à 15°. Dans ces conditions, les espaceurs latéraux 6 réalisent un effet d'ombrage important lors de l'implantation ce qui permet d'implanter du matériau barrière sur 1,5nm sous les espaceurs 6 de chaque coté du canal. Ainsi, lors de l'étape de recuit de diffusion les dopants doivent traverser 1,5nm de zone à diffusion réduite pour atteindre le canal de conduction.

Cette architecture et ce procédé de fabrication sont particulièrement intéressants dans une intégration avec un substrat de type semi-conducteur sur isolant. De manière préférentielle, la zone 11 de diffusion modifiée relie l'espaceur 8 à la couche électriquement isolante 5, c'est-à-dire qu'elle occupe toute l'épaisseur du film semi-conducteur 2 ce qui permet de maîtriser complètement la longueur du canal sur toute son épaisseur.

## Revendications

1. Dispositif à effet de champ comportant :
- un substrat (3) comportant successivement un substrat de support (4), une couche électriquement isolante (5) et un film semi-conducteur (2),
- une électrode de grille (7) ayant des parois latérales recouvertes par des espaceurs latéraux (8),
- des première et seconde électrodes (6) de source/drain formées dans le film en matériau semi-conducteur (2), les première et seconde électrodes (6) de source/drain étant disposées de part et d'autre de l'électrode de grille (7) et dopées par une première impureté dopante,
- un canal de conduction formé dans le film semi-conducteur (2) et séparant les première et seconde électrodes (6) de source/drain, le canal de conduction étant disposé face à l'électrode de grille (7),
dispositif **caractérisé en ce que**, dans le film semi-conducteur (2), le canal de conduction et la première électrode de source/drain (6) sont séparés par une zone de diffusion modifiée (11) disposée dans le prolongement d'un des espaceurs latéraux (8) et reliant la couche électriquement isolante (5) à l'espaceur latéral (8) associé, la zone de diffusion modifiée comportant un élément barrière de diffusion de la première impureté dopante, les concentrations en élément barrière dans le canal de conduction et la première électrode de source/drain (6) étant inférieures à la concentration en élément barrière dans la zone de diffusion modifiée (11).

2. Dispositif selon la revendication 1 **caractérisé en ce que** l'étendue latérale de la zone de diffusion modifiée (11) est inférieure à l'étendue latérale de l'espaceur latéral (8) associé.

3. Dispositif selon l'une des revendications 1 et 2 **caractérisé en ce que** les première et seconde électrodes de source/drain (6) sont chacune séparées du canal par une zone de diffusion modifiée (11) disposée dans le prolongement d'un des espaceurs latéraux (8).

4. Procédé de fabrication d'un dispositif à effet de champ **caractérisé en ce qu'**il comporte :
- prévoir un substrat (3) muni d'un film en matériau semi-conducteur (2a) recouvert par une électrode de grille (5) sacrificielle et des espaceurs latéraux (8), les espaceurs latéraux recouvrant les parois latérales de l'électrode de grille (1) sacrificielle,
- éliminer l'électrode de grille (1) sacrificielle de manière à former une zone vide bordée par les espaceurs latéraux (8),
- réaliser une implantation ionique tiltée d'un élément barrière de diffusion avec un angle non nul par rapport à la surface du film en matériau semi-conducteur (4) de manière à former dans le film en matériau semi-conducteur (2a), à travers la zone vide, sous les espaceurs latéraux (8), une zone (11) dopée par un élément barrière de diffusion à une première impureté dopante des futures électrodes de source/drain (6),
- former une électrode de grille (7) en matériau électriquement conducteur.

5. Procédé selon la revendication 4 **caractérisé en ce qu'**il comporte la protection des électrodes (6) de source/drain lors de l'implantation de l'élément barrière de diffusion.

6. Procédé selon la revendication 5 **caractérisé en ce qu'**il comporte avant l'élimination de la grille sacrificielle (1), l'implantation tiltée de la première impureté dopante pour former une première zone de dopage, la première zone de dopage étant séparée du canal de conduction par la zone (11) dopée en élément barrière de diffusion.

7. Procédé selon l'une quelconque des revendications 4 à 6, dans lequel le substrat (3) comporte successivement un substrat de support (4), une couche électriquement isolante (5) et le film semi-conducteur (2), l'implantation ionique tiltée de l'élément barrière de diffusion est réalisée de manière à que la zone (11) dopée relie l'espaceur latéral (8) à la couche électriquement isolante (5).

8. Procédé selon l'une quelconque des revendications 4 à 7, **caractérisé en ce qu'**il comporte le dépôt d'un matériau de recouvrement (10) sur le substrat (3) de manière à recouvrir l'électrode de grille sacrificielle (1) et **en ce qu'**il comporte la gravure partielle d'un matériau de recouvrement (10) pour accéder à l'électrode de grille sacrificielle (1), le substrat (3) étant protégé durant l'élimination de la grille sacrificielle (1).
